# EUROPEAN PATENT APPLICATION

(11) **EP 1 950 023 A1**
(43) Date of publication of application: **30.07.2008**
(21) Application number: 06811894.2
(22) Date of filing: 17.10.2006
(51) Int. Cl.: B29C 43/34, B29C 43/18, H01L 21/56

(54) **MOLDING APPARATUS FOR RESIN ENCAPSULATION OF ELECTRONIC PART**

(30) Priority: 04.11.2005 JP 2005320280
(71) Applicant: Towa Corporation, Kyoto 6018105 (JP)
(72) Inventor: NAKAMURA, Mamoru, Kyoto-shi Kyoto 601-8105 (JP); HANASAKI, Masanori, Kyoto-shi Kyoto 601-8105 (JP)
(74) Representative: Lipscombe, Martin John
(86) International application number: PCT/JP2006/320639
(87) International publication number: WO 2007/052467

(57) **Abstract**

An apparatus (50) includes a resin supplying mechanism (40) supplying a resin material (41) to a molding assembly (1, 2, 3). A supplying portion (46) of the resin supplying mechanism (40) is provided with a resin tray (42). The resin tray (42) includes a tray slit member (42B) having a plurality of openings extending in a direction perpendicular to the opening direction of a shutter (42A). The resin material (41) in a required amount is guided into the plurality of openings of the slit member (42B), and thereafter, substantially simultaneously with the shutter (42A) being opened, supplied to a cavity space portion (9).

## Description

### TECHNICAL FIELD

The present invention relates to an apparatus for sealing and molding with a resin an electronic component such as a semiconductor chip including an IC (Integration Circuit) attached on a substrate. In the apparatus, the electronic component is sealed and molded as being immersed in a molten resin material in a mold assembly. More specifically, the present invention relates to a mechanism supplying a resin material into the aforementioned apparatus.

### BACKGROUND ART

Conventionally, a mold assembly for resin sealing and molding of an electronic component has been used. The mold assembly has an upper mold and a lower mold. When this mold assembly is used, a substrate having an electronic component mounted is attached to a prescribed position in the upper mold. In this state, a resin material is supplied by a resin supplying mechanism to a cavity formed at the lower mold. Thereafter, in the mold assembly, the resin material is heated and molten. In this state, as the mold assembly is closed, the electronic component is immersed in the molten resin material. Thereafter, when a prescribed time elapses, the molten resin material cures. As a result, a molded product having the electronic component contained in the resin material on the substrate is completed.

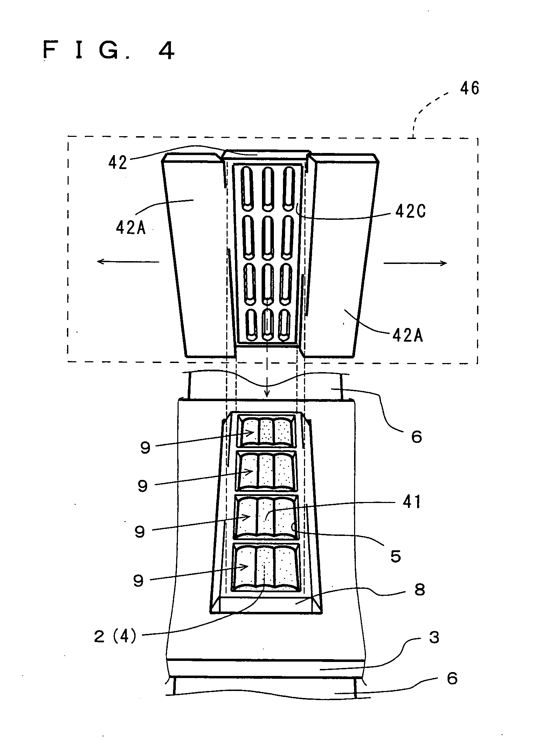

As the foregoing apparatus, for example Japanese Patent Laying-Open No. 2005-225133 discloses in page 5 and Fig. 4 an apparatus having a three-mold structure constituted of an upper mold, a lower mold, and an intermediate mold.

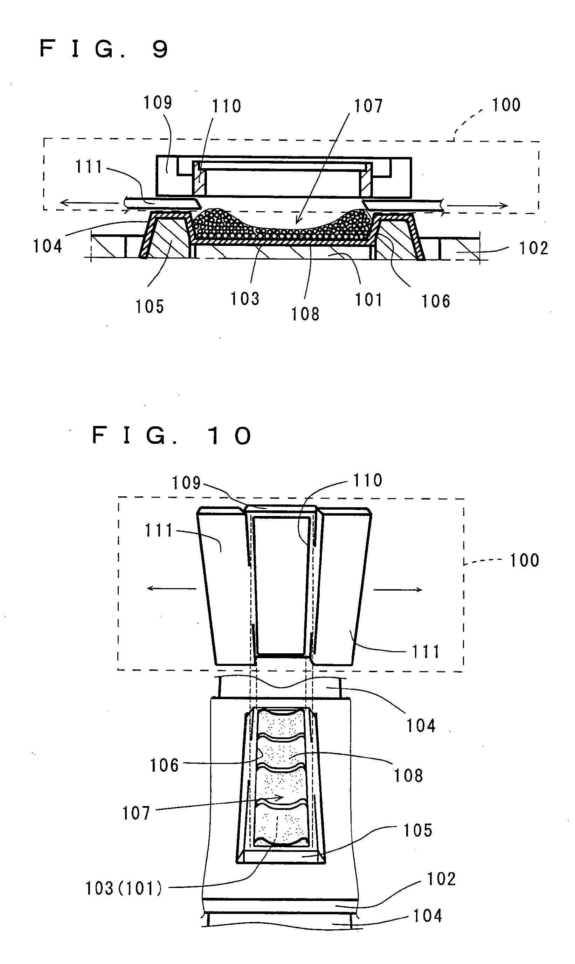

In the apparatus, as shown in Figs. 9 and 10, tension is applied to a release film 104 by a lower mold 101 and an intermediate mold 102. Release film 104 covers the entire cavity including a lower cavity mold surface 103 of lower mold 101 and a cavity surface 106 of a cavity member 105. A cavity space portion 107 is formed by the upper mold, intermediate mold 102 and lower mold 101. It is noted that the upper mold is not shown in Figs. 9 and 10 for the sake of clarity.

Fig. 10 shows, in one drawing, a view of a cavity space portion 107 as seen from a diagonally above point and a view of a resin tray 109 to be described later as seen from a diagonally below point, so that their correspondence is easily understood.

Figs. 9 and 10 show a resin material unit 100 as a resin supplying mechanism. Resin material unit 100 includes a storing portion and an adjusting portion, and supplies resin material 108 in a required amount to cavity space portion 107. In the following, resin material unit 100 will specifically be described.

In the storing portion of resin material unit 100, powdery/particulate resin material 108 is stored. The adjusting portion measures resin material 108 stored in the storing portion. This measurement is performed in a measurement feeder. The amount of resin material 108 is adjusted to a preset value.

Resin material 108 in the preset amount falls from a resin guiding mechanism into a resin tray 109. Here, if all resin material 108 falls altogether into a space in an opening member 110 of resin tray 109, it will not be evenly distributed over the entire region of cavity space portion 107. Accordingly, resin material 108 is measured and guided into opening member 110 for a plurality of times (here, four times). Thereafter, as shown in Figs. 9 and 10, a shutter 111 provided at resin tray 109 is opened. Thus, resin material 108 having been guided into opening member 110 is supplied into cavity space portion 107.
Patent Document 1: Japanese Patent Laying-Open No. 2005-225133 (page 5, Fig. 4)

### DISCLOSURE OF THE INVENTION

### PROBLEMS TO BE SOLVED BY THE INVENTION

Recently, substrates are becoming wider and thinner. Electronic components (semiconductor chips) are becoming extremely smaller and extremely thinner. A plurality of electronic components attached on one substrate are covered by a resin all at once. Therefore, the thickness in the vertical direction of a cavity (cavity space portion 107) is very small. The cavity horizontal surface (lower mold cavity surface 103) is very wide. Accordingly, among powdery/particulate resins, a granular resin is particularly employed as resin material 108.

If conventional resin material unit 100 is used in the situation described above, the following problems occur.

Firstly, as shown in Figs. 9 and 10, a problem occurs that resin material 108 on the periphery side swells in cavity space portion 107. This is caused by use of shutter 111 when resin material 108 is supplied to cavity space portion 107. More specifically, the aforementioned problem occurs for the following reasons.

When shutter 111 is opened, resin material 108 on shutter 111 falls. On the other hand, part of resin material 108 rests on shutter 111 and in this state moves in the opening direction of shutter 111 (horizontal direction). Thereafter, the horizontally moving resin material 108 hits each inner side face of resin tray 109 and thereafter falls into cavity space portion 107. Accordingly, the amount of resin material 108 falling near the periphery of cavity space portion 108 is greater than the amount of resin material 108 falling at the center of cavity space portion 108. As a result, resin material 108 in cavity space portion 107 swells near the periphery of cavity space portion 107.

If resin material 108 having extremely swelled near the periphery of cavity space portion 107, more specifically, swelled higher than cavity space portion 107 melts, it leaks to the outside of cavity space portion 107. As a result, improper molding such as flash, wire sweep and incomplete filling (void) may occur.

As the resin molded products (packages) become broader and thinner, such a tendency increases that molten resin material 108 is not distributed evenly over the entire region from the periphery to center of cavity space portion 107. In this case also, in the state where the portion near the periphery of molten resin material 108 swells, the electronic component is immersed in molten resin material 108 to be sealed and molded. As a result, by the above-described reasons, improper molding such as flash, wire sweep and incomplete filling (void) occurs.

Secondly, there is a problem that if resin material 108 is intermittently supplied into resin tray 109 for several times, the improper molding such as flash, wire sweep and incomplete filling is further likely to occur. This problem occurs because resin material 108 is intermittently supplied to cavity space portion 107 in a manner of a compressional wave in the top-bottom direction of Fig. 10 and therefore is not evenly distributed over the entire region of cavity space portion 107.

Thirdly, there is such a problem that the resin supplying efficiency is reduced because resin material 108 cannot smoothly be supplied into cavity space portion 107.

This problem is assumed to be attributed to a powdery/particulate resin (granular resin) or the like employed as resin material 108, which includes powder or particles that easily disperses because of its extremely small diameter. More specifically, the aforementioned problem occurs as follows.

Since powder or particles having extremely small diameter easily disperses, it melts before being supplied into cavity space portion 107. Accordingly, the powdery/particulate resin cakes. A cluster of such caked resin formed in resin material unit 100 results in clogging or residence. As a result, resin material 108 cannot smoothly be supplied into cavity space portion 107. Accordingly, the resin supplying efficiency is reduced.

The present invention has been made in consideration of the aforementioned problems, and an object thereof is to prevent occurrence of improper molding such as flash, wire sweep and incomplete filling, by evenly distributing a resin material over the entire region in a mold assembly (cavity space portion).

Another object of the present invention is to remove in a resin supplying mechanism an unnecessary powdery or particulate resin included in a resin material, which has very small diameter and which easily disperses.

Still another object of the present invention is to prevent a powdery or particulate resin from caking in a resin supplying mechanism.

### MEANS FOR SOLVING THE PROBLEMS

A resin sealing and molding apparatus for an electronic component according to the present invention includes a molding assembly for resin sealing and molding of the electronic component. The molding assembly includes an upper mold to which a substrate having the electronic component mounted may be attached and a lower mold having a cavity space portion receiving the electronic component. In the apparatus, the electronic component is immersed in a molten resin material in the cavity space portion when the upper mold and the lower mold are closed. The apparatus includes a resin supplying mechanism supplying a powdery or particulate resin material to the cavity space portion.

The resin supplying mechanism includes a storing portion storing the resin material, and a measuring portion taking out the resin material only in a required amount by measurement, out of the resin material stored in the storing portion. The resin supplying mechanism includes a guiding portion guiding the resin material in the required amount to a resin tray including a slit member having a plurality of openings extending parallel with each other. The apparatus includes a supplying portion having the resin tray and a shutter provided immediately below the resin tray so as to be openable and closable in a direction substantially perpendicular to a direction in which the plurality of openings extend. The supplying portion supplies the resin material in the required amount to the cavity space portion when the shutter is opened.

The guiding portion includes a guiding slit member having a plurality of openings corresponding to the plurality of openings of the slit member. The guiding portion allows the resin material in the required amount to fall from the plurality of openings of the guiding slit member to the plurality of openings of the tray slit member in a state where the resin tray continuously moves corresponding to the resin material in the required amount.

The measuring portion includes a removing portion removing a fine unnecessary resin included in the resin material before the resin material arrives at the guiding portion.

At least one of the storing portion, the measuring portion, the guiding portion and the supplying portion is exposed to an atmosphere of such temperature that the resin material attains temperature of at most 15°C.

### EFFECTS OF THE INVENTION

According to the present invention, since a resin material can evenly be distributed over the entire region in a mold assembly (cavity space portion), occurrence of improper molding such as flash, wire sweep and incomplete filling is prevented. Also, since the resin supplying efficiency is drastically improved, the productivity of after-sealing substrates (molded products) can drastically be improved.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 schematically shows an overall configuration of a resin sealing and molding apparatus for an electronic components of the present invention.
Fig. 2 is a cross-sectional view schematically showing a supplying portion of a resin supplying mechanism of the apparatus shown in Fig. 1.
Fig. 3 is a perspective view schematically showing the supplying portion of the resin supplying mechanism of the apparatus shown in Fig. 1.
Fig. 4 is a perspective view schematically showing a supplying portion of a resin supplying mechanism according to another example of the apparatus shown in Fig. 1.
Fig. 5 is a cross-sectional view schematically showing a guiding portion of the resin supplying mechanism of the apparatus shown in Fig. 1.
Fig. 6 is a perspective view schematically showing the guiding portion of the resin supplying mechanism of the apparatus shown in Fig. 1.
Fig. 7 is a side view schematically showing a removing portion of the resin supplying mechanism of the apparatus shown in Fig. 1.
Fig. 8 is a cross-sectional view along line VIII-VIII in Fig. 7, schematically showing the removing portion of the resin supplying mechanism of the apparatus shown in Fig. 1.
Fig. 9 is a cross-sectional view schematically showing a state immediately after a resin material is supplied from a resin material unit to a mold assembly in a conventional resin sealing and molding apparatus for an electronic component.
Fig. 10 is a perspective view schematically showing a state immediately after a resin material is supplied from a resin material unit to a mold assembly in a conventional resin sealing and molding apparatus for an electronic component.

### DESCRIPTION OF THE REFERENCE SIGNS

1 upper mold, 1A upper mold surface, 2 lower mold, 3 intermediate mold, 4 lower cavity surface, 5 cavity surface, 6 release film, 7 substrate attaching portion, 8 cavity member, 9 cavity space portion (cavity), 10 pressing mechanism, 20 supplying/taking-out mechanism, 30 substrate storing mechanism, 31 before-sealing substrate, 32 after-sealing substrate (molded product), 33 in-magazine, 34 out-magazine, 35 electronic component (semiconductor chip), 36 substrate, 37 resin molded product (package), 38 substrate periphery, 39 non-mounted surface, 40 resin supplying mechanism, 41 resin material (powdery/particulate resin), 41X unnecessary resin, 42 resin tray, 42A shutter, 42B, 42C tray slit member, 43 storing portion, 44 measuring portion, 44A trough, 44B resin moving surface, 45 guiding portion, 45A resin guiding device, 45B guiding portion slit member, 46 supplying portion, 47 removing portion, 50 resin sealing and molding apparatus, 100 resin material unit, 101 lower mold, 102 intermediate mold, 103 lower mold cavity surface, 104 release film, 105 cavity member, 106 cavity surface, 107 cavity space portion, 108 resin material, 109 resin tray, 110 opening member, 111 shutter.

### BEST MODES FOR CARRYING OUT THE INVENTION

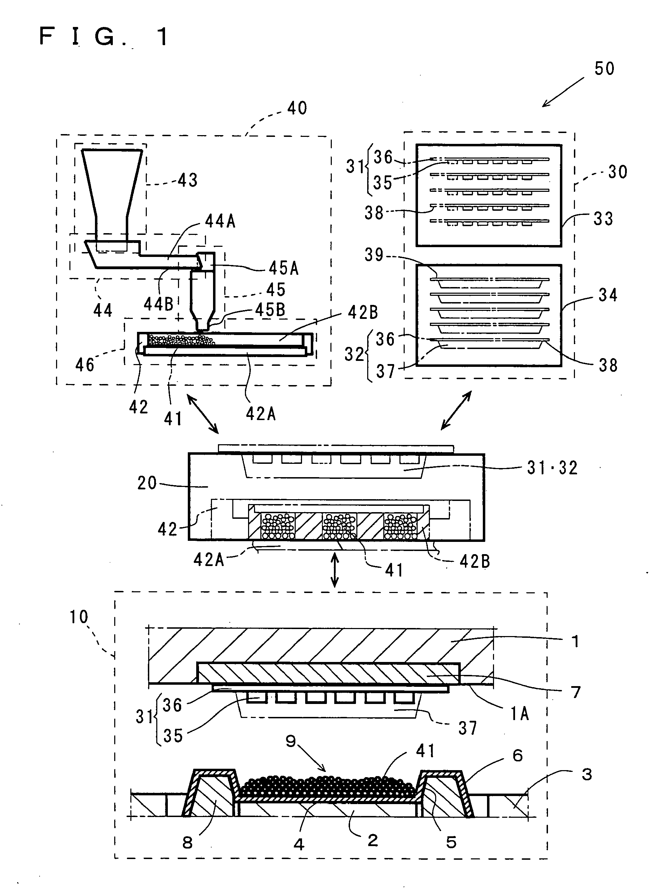

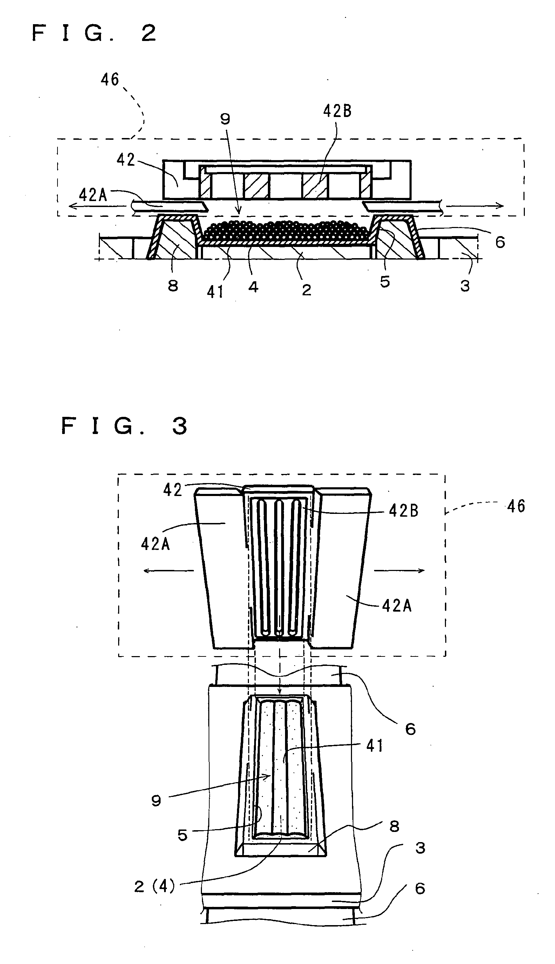

In the following, referring to Figs. 1-8, a resin sealing and molding apparatus for an electronic component of an embodiment will be described. Fig. 1 schematically shows an overall configuration of the resin sealing and molding apparatus for an electronic component of the present invention. Figs. 2-8 are cross sectional views and perspective views schematically showing substantial part of a resin supplying mechanism of the apparatus shown in Fig. 1.

As shown in Fig. 1, a resin sealing and molding apparatus 50 for an electronic component (hereinafter simply referred to as "apparatus 50") of the present embodiment includes a pressing mechanism 10. Pressing mechanism 10 has a mold assembly having a three-mold structure. The mold assembly is constituted of an upper mold 1, a lower mold 2, and an intermediate mold 3.

Apparatus 50 includes a film supplying mechanism (not shown). The film supplying mechanism is for covering lower mold 2 with a tensioned release film 6. More specifically, a cavity of lower mold 2 is covered by release film 6. The cavity is formed by a lower cavity surface 4 and cavity surface 5.

Apparatus 50 includes a supplying/taking-out mechanism 20. Supplying/taking-out mechanism 20 has a function of supplying a before-sealing substrate 31 and resin material 41 in a required amount separately and substantially at the same time into the mold assembly. Supplying/taking-out mechanism 20 also has a function of taking out an after-sealing substrate 32 from the mold assembly.

Apparatus 50 also includes a substrate storing mechanism 30. Substrate storing mechanism 30 has an in-magazine 33 storing before-sealing substrate 31 before being transferred to the mold assembly by supplying/taking-out mechanism 20. Substrate storing mechanism 30 has an out-magazine 34 storing after-sealing substrate 32 (molded product) being taken out from the mold assembly by supplying/taking out mechanism 20.

Apparatus 50 includes a resin supplying mechanism 40 supplying resin material 41 in a required amount into the cavity of the mold assembly. Resin supplying mechanism 40 transfers resin material 41 in the required amount having been guided into resin tray 42 to supplying/taking out mechanism 20.

Pressing mechanism 10 has a pressing machine closing and opening upper mold 1 and lower mold 2, and a pressing machine for intermediate mold 3. As such pressing machines, for example a device utilizing water pressure, oil pressure or fluid such as air, an electric pressing machine or the like is used. These two pressing machines close and open the mold assembly, in a single action or as interlocking with each other.

As shown in Fig. 1, upper mold 1 includes, on an upper mold surface 1A, a substrate attaching portion 7 to which before-sealing substrate 31 or after-sealing substrate 32 is attached. Before-sealing substrate 31 and after-sealing substrate 32 each include a plurality of electronic components 35 (semiconductor chips) arranged in a matrix fashion on substrate 36 and wires (not shown) electrically connecting each of the plurality of electronic components 35 to substrate 36.

After-sealing substrate 32 has a resin-molded product 37 (package), a substrate periphery 38, and a non-mounting surface 39. Resin-molded product 37 (package) is the plurality of electronic components 35 and the wires as included in resin material 41. Substrate periphery 38 is the region without resin-molded product 37 on a main surface where electronic component 35 is attached. Non-mounting surface 39 is a main surface where electronic component 35 is not mounted, and abuts on substrate attaching portion 7.

The above-described apparatus 50 of the present embodiment is for sealing and molding wire-bonded electronic component 35 with a resin. On the other hand, the resin sealing and molding apparatus for an electronic component of the present invention is not limited thereto, and it may be for sealing and molding with a resin a flip-chip substrate on which electronic component 35 without wiring is mounted, a wafer level package or the like.

As shown in Fig. 1, resin material 41 is a granular resin (powdery/particulate resin), and it is supplied from resin supplying mechanism 40 to cavity space portion 9 in an amount required for covering a plurality of resin-molded products 37 on substrate 36 all at once.

Cavity space portion 9 is formed by covering the entire cavity including lower cavity surface 4 and cavity surface 5 with release film 6 which is tensioned by lower mold 2 and intermediate mold 3 fitting into each other. Fig. 2 shows the state where cavity space portion 9 is formed. This state corresponds to the state shown in Fig. 9 which has been described in connection with the conventional technique.

In order to facilitate understanding of the present invention, upper mold 1 is not shown in Figs. 2 and 3. In Fig. 3, in order to facilitate understanding of the resin supplying state shown in Fig. 2, two types of perspective views are included in one drawing so that the upper surface of cavity space portion 9 and the lower surface of resin tray 42 to be described later can both be seen simultaneously.

Although not shown, the mold assembly includes a plurality of heaters for heating and melting resin material 41 supplied to cavity space portion 9. The plurality of heaters are arranged substantially immediately below lower cavity surface 4. For example, they are cartridge heaters, flexible heaters and the like, for melting resin material 41. Resin material 41 melts by the heat applied from the heaters, and it cures after a prescribed time elapses. Thus, resin-molded product 37 as a cured resin is formed. It is noted that upper mold 1 and intermediate mold 3 may also accommodate heaters.

Supplying/taking-out mechanism 20 has a carrying mechanism (not shown) that moves substantially horizontally, to enter a space between upper mold 1 and intermediate mold 3, that is, a space between upper mold surface 1A and upper surface of intermediate mold 3, and that can exit from the space. The carrying mechanism is for example a mechanical chuck carrying mechanism, a robot arm carrying mechanism or the like. The upper part of the carrying mechanism can supply before-sealing substrate 31 and take out after-sealing substrate 32. On the other hand, the lower part of the carrying mechanism can supply resin material 41 in a required amount with resin tray 42 to the mold assembly. That is, the carrying mechanism has both the function of supplying and taking out the substrate, and the function of supplying the resin material.

In-magazine 33 and out-magazine 34 of substrate storing mechanism 30 are different from each other in that the former stores before-sealing substrate 31 and the latter stores after-sealing substrate 32. On the other hand, they both store substrate 36 and therefore their basic constituents are the same.

In Fig. 1, although in-magazine 33 and out-magazine 34 are arranged next to each other in the vertical direction, they may be arranged next to each other in the left-right direction. When in-magazine 33 and out-magazine 34 are arranged next to each other in the vertical direction, either of in-magazine 33 and out-magazine 34 may be arranged on the upper side, or on the lower side.

For each in-magazine 33 and out-magazine 34, a slit-type magazine cassette (not shown) is employed, in which a plurality of substrates (31, 32) in a required number are placed, with a prescribed distance from each other. Similarly to the state of substrates 36 in the mold assembly, substrates 36 are stored in the magazine cassette such that electronic components 35 (resin-molded products 37) are oriented downwardly.

As shown in Fig. 1, resin supplying mechanism 40 includes a storing portion 43, a measuring portion 44, a guiding portion 45, and a supplying portion 46. Storing portion 43 stores resin material 41 to be supplied to cavity space portion 9. Measuring portion 44 measures resin material 41 so as to take out only in a preset amount resin material 41 having been stored in storing portion 43. Guiding portion 45 guides, by means of resin guiding device 45A, resin material 41 in the required amount as measured by measuring portion 44 to resin tray 42. Resin tray 42 includes shutter 42. It opens shutter 42A so that resin material 41 in the required amount fallen from guiding portion 45 is supplied to cavity space portion 9.

As shown in Figs. 2 and 3, supplying portion 46 includes, in resin tray 42, a tray slit member 42B having a plurality of openings extending in the direction perpendicular to the opening direction of shutter 42A. Resin material 41 in the required amount is retained in the plurality of openings (in this case, three openings) of tray slit member 42B, which is supplied to cavity space portion 9 substantially simultaneously with shutter 42A being opened.

Accordingly, when resin material 41 is supplied to cavity space portion 9, as shown in Fig. 2, no extreme swelling as in a conventional example (see Fig. 9) is formed near the periphery of the cavity. That is, resin material 41 is evenly distributed over the entire region of cavity space portion 9. This is because resin material 41 does not move in the opening direction of shutter 42A but it free-falls from the plurality of openings of tray slit member 42B substantially simultaneously with shutter 42A being opened.

As shown in Fig. 3, tray slit member 42B has a plurality of, i.e., three, linear openings extending parallel with each other along the longitudinal direction, so that resin material 41 in the required amount can be supplied to cavity space portion 9.

Another possible tray slit member 42C is a slit of the matrix type, as shown in Fig. 4. Tray slit member 42C is for individually supplying cavity space portions 9 being divided into a plurality of numbers (in this case, four) with respective resin material 41 in the required amounts. To this end, tray slit member 42C is divided into four in the long side and into three in the short side, to have twelve openings. When this tray slit member 42C is employed, similarly to the case where tray slit member 42B is employed, resin material 41 is evenly distributed over the entire region in each of the plurality of cavity space portions 9.

It is noted that, in order to facilitate understanding of the invention, upper mold 1 is not shown in Fig. 4. In order to facilitate understanding of the resin supplying state, a perspective view of cavity space portion 9 and a perspective view of resin tray 42 (supplying portion 46) as seen from different direction are contained in one drawing.

As shown in Figs. 2-4, resin material 41 is extremely evenly distributed over the entire region of cavity space portion 9. Therefore, when resin material 41 melts by heating, leakage of the resin to the outside of cavity space portion 9 is prevented. Also, flow of the resin in cavity space portion 9 is reduced. As a result, improper molding such as flash, wire sweep and incomplete filling (void) is prevented.

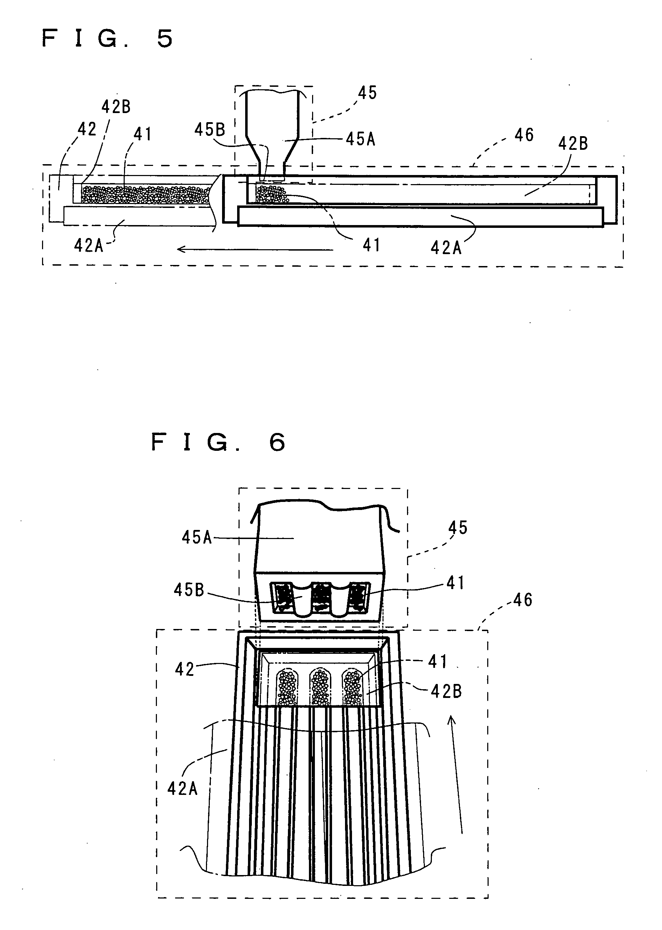

As shown in Figs. 5 and 6, guiding portion 45 includes a guiding portion slit member 45B having a plurality of openings formed corresponding to the plurality of openings of slit member 42B. In a state where resin tray 42 is moving corresponding to the amount of resin material 41 guided to resin tray 42, guiding portion 45 allows resin material 41 to continuously fall from the plurality of openings of guiding portion slit member 45B to the plurality of openings of tray slit member 42B.

It is desirable that the shape of the plurality of openings of guiding portion slit member 45B shown in Fig. 6 is rounded, so that the plurality of openings of tray slit member 42B and the plurality of openings of guiding portion slit member 45B correspond to each other. This enables resin material 41 to be efficiently supplied from the plurality of openings of guiding portion slit member 45 to the plurality of openings of tray slit member 42B.

As has been described referring to Figs. 5 and 6, when resin material 41 is continuously guided from guiding portion 45 to resin tray 42, it can be prevented from being supplied in a manner of a compressional wave in the top-bottom direction as in a conventional example. As shown in Fig. 2, resin material 41 in a required amount 41 can extremely evenly be distributed over the entire region of cavity space portion 9.

In Fig. 6, in order to facilitate understanding of the resin guiding state shown in Fig. 5, a perspective view of the bottom surface of resin guiding device 45A (guiding portion 45) and a perspective view of the top surface of resin tray 42 (supplying portion 46) to be described later are contained in one drawing.

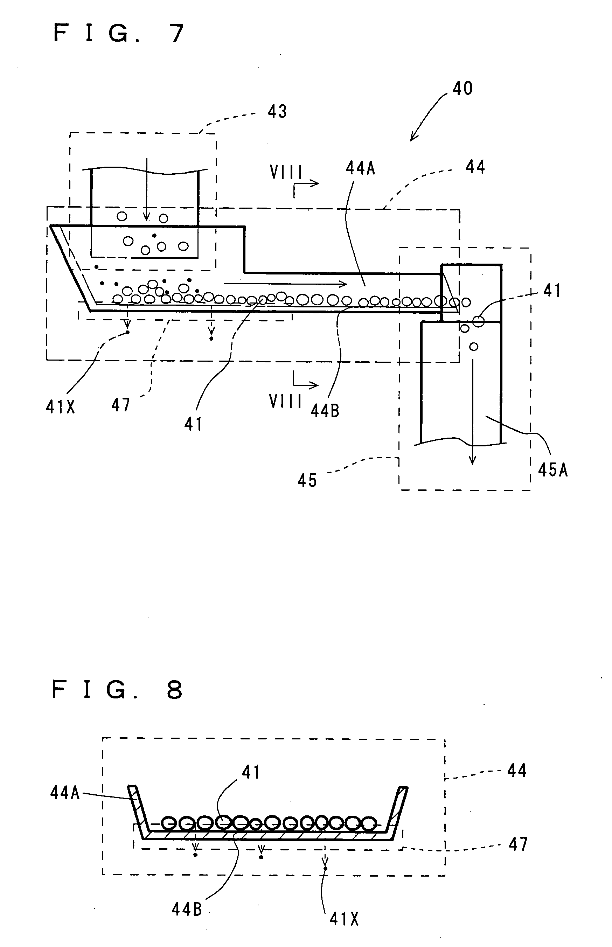

Next, referring to Figs. 7 and 8, storing portion 43, measuring portion 44, and guiding portion 45 will be described.

As resin material 41 is a powdery/particulate resin (granular resin), a powdery or particulate resin having extremely small diameter and being easily dispersed is included. The resin powder or particles of small diameter melt before being supplied to cavity space portion 9. Accordingly, the particles or powder cake. Accordingly, in apparatus 50 of the present embodiment, as shown in Figs. 7 and 8, a removing portion 47 is provided at measuring portion 44 of resin supplying mechanism 40, in order to remove powder or particles of resin material 41 with extremely small diameter, that is, unnecessary resin 41X.

In particular, clogging or residence attributed to unnecessary resin 41X is likely to occur near the exit of a trough 44A in measuring portion 44. Accordingly, it is desirable that unnecessary resin 41X is completely removed from resin material 41 when resin material 41 passes through the position corresponding to the cross section along line VIII-VIII in Fig. 7, that is, the cross section shown in Fig. 8.

Therefore, as shown in Fig. 7, removing portion 47 is provided on the storing portion 43 side relative to VIII-VIII cross sectional line. Thus, resin material 41 arrives at resin guiding device 45A in a state where unnecessary resin 41X is removed. A possible method of removing unnecessary resin 41X is to form removing portion 47, that is, the bottom surface of trough 44A to be mesh-like. The mesh-like bottom surface of trough 44A functions as a sieve. Thus, fine and easily dispersed unnecessary resin 41X falls from the bottom surface of trough 44A as shown by the arrows in Figs. 7 and 8.

Another possible method of removing unnecessary resin 41X may be to forcibly suction only unnecessary resin 41X at storing portion 43, measuring portion 44, and guiding portion 45.

Resin moving surface 44B of trough 44A has a flat shape, so that resin material 41 can smoothly arrive at guiding portion 45 in a state where unnecessary resin 41X is removed.

As described above, as shown in Figs. 7 and 8, owing to resin supplying mechanism 40 having removing portion 47, resin material 41 can continuously and smoothly pass inside resin supplying mechanism 40 and the plurality of openings of slit member 42B in a state where unnecessary resin 41X is removed.

Therefore, according to the resin sealing and molding apparatus for an electronic component of the present embodiment, fine particles/powder of the resin does not cake. Thus, occurrence of clogging or residence in resin supplying mechanism 40 is prevented. Also, since resin material 41 is smoothly supplied from resin supplying mechanism 40 to cavity space portion 9 in a state where unnecessary resin 41X is removed, the resin supplying efficiency can drastically be improved.

Another factor for formation of the clusters of resin as in a conventional example is, in addition to that resin material 41 includes fine and easily dispersed unnecessary resin 41X, that the whole mold assembly is heated for melting resin material 41. More specifically, not only pressing mechanism 10 but also resin supplying mechanism 40 is heated is the factor for occurrence of unnecessary resin 41X.

Generally, by heating of the heaters in apparatus 50, the temperature of resin supplying mechanism 40 (storing portion 43, measuring portion 44 including removing portion 47, guiding portion 45, and supplying portion 46) becomes equal to or higher than the temperature outside apparatus 50.

The inventors of the present invention have found that, in order to mainly improve the resin supplying efficiency, it is preferable that resin material 41 is used in an atmosphere in which at least one of storing portion 43, measuring portion 44 (including removing portion 47), guiding portion 45, and supplying portion 46 has a temperature lower than the outside temperature, preferably at most at 15°C. It is noted that, if resin material 41 becomes lower than 0°C, freezing attributed to the cooling action facilitates caking of fine powdery/particulate resin. Therefore, it is necessary not to make resin material 41 be equal to or lower than 0°C.

Accordingly, it is desirable that the temperature of resin material 41 is adjusted to the temperature that is lower than the outside air temperature and that is at least the temperature not facilitating freezing. More specifically, it is desirable that the temperature of resin material 41 is adjusted to the temperature higher than 0°C and at most 15°C. To this end, it is necessary for apparatus 50 to have the capacity of cooling at least one of storing portion 43, measuring portion 44 (including removing portion 47), guiding portion 45, and supplying portion 46. Accordingly, apparatus 50 may have a cooling device capable of cooling all of, or at least selected one of, storing portion 43, measuring portion 44 (including removing portion 47), guiding portion 45, and supplying portion 46.

Although in the above present embodiment the description has been given as to the resin sealing and molding apparatus including the mold assembly having the three-mold structure constituted of upper mold 1, lower mold 2 and an intermediate mold 3, the present invention is also applicable to a resin sealing and molding apparatus including a mold assembly having a two-mold structure constituted of upper mold 1 and lower mold 2.

In the mold assembly having the three-mold structure, it is desirable to prevent occurrence of void in resin material 41 molten in cavity space portion 9. Therefore, vacuum may be created in cavity space portion 9 by forcibly exhausting air from the mold assembly in a state where the mold assembly is closed. In order to surely create vacuum, it is desirable that a clearance between any two of upper mold 1, lower mold 2 and intermediate mold 3 is sealed by a seal member provided thereto.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A resin sealing and molding apparatus for an electronic component, comprising:
a molding assembly (1, 2, 3) for resin sealing and molding of the electronic component, including an upper mold (1) to which a substrate (36) having the electronic component (35) mounted may be attached and a lower mold (2) having a cavity space portion (9) receiving said electronic component, said electronic component (35) being immersed in a molten resin material (41) in said cavity space portion (9) when said upper mold (1) and said lower mold (2) are closed; and
a resin supplying mechanism (40) supplying a powdery or particulate resin material (41) to said cavity space portion (9), wherein
said resin supplying mechanism (40) includes
a storing portion (43) storing said resin material,
a measuring portion (44) taking out said resin material (41) only in a required amount by measurement, out of said resin material (41) stored in said storing portion (43),
a guiding portion (45) guiding said resin material (41) in the required amount to a resin tray (42) including a slit member (42B) having a plurality of openings extending parallel with each other, and
a supplying portion (46) having said resin tray (42) and a shutter (42A) provided immediately below said resin tray (42) so as to be openable and closable in a direction substantially perpendicular to a direction in which said plurality of openings extend, said supplying portion (46) supplying said resin material (41) in the required amount to said cavity space portion (9) when said shutter (42A) is opened.

2. The resin sealing and molding apparatus for the electronic component according to claim 1, wherein
said guiding portion (45) includes a guiding slit member (45B) having a plurality of openings corresponding to said plurality of openings of said slit member (42B), said guiding portion (45) allowing said resin material (41) in the required amount to fall from said plurality of openings of said guiding slit member (45B) to said plurality of openings of said tray slit member (42B) in a state where said resin tray (42) continuously moves corresponding to said resin material (41) in the required amount.

3. The resin sealing and molding apparatus for the electronic component according to claim 1, wherein
said measuring portion (44) includes a removing portion (47) removing a fine unnecessary resin (41X) included in said resin material (41) before said resin material (41) arrives at said guiding portion (45).

4. The resin sealing and molding apparatus for the electronic component according to claim 1, wherein
at least one of said storing portion (43), said measuring portion (44), said guiding portion (45) and said supplying portion (46) is exposed to an atmosphere of such temperature that said resin material (41) attains temperature of at most 15°C.
